# EUROPÄISCHE PATENTANMELDUNG

(11) **EP 0 782 076 A1**
(43) Veröffentlichungstag der Anmeldung: **02.07.1997**
(21) Anmeldenummer: 96119483.4
(22) Anmeldetag: 04.12.1996
(51) Int. Cl.: G06F 12/06

(54) **Anordnung zum Ermitteln der Konfiguration eines Speichers**

(30) Priorität: 29.12.1995 DE 19549062
(71) Anmelder: SIEMENS AKTIENGESELLSCHAFT, 80333 München (DE)
(72) Erfinder: Brandt, Ulrich, Dipl.-Ing., 81673 München (DE); Kropsch, Norbert, Dipl.-Ing., 80673 München (DE)

(57) **Zusammenfassung**

Erfindungsgemäß ist zumindest eine der von einer Speicheransteuerung (SAS) zu einem Speicher (SP) wirkenden Steuer- bzw. Adreßleitungen (SL1..8, ADL1..4) als zusätzliche Kapazitäts-, Vorhandensein bzw. Typenleitung bestimmt. Über diese Leitungen werden mit Hilfe von Kodiermitteln (R1..8,R,RV,RT) Kapazitäts-, Vorhandensein und Typeninformationen (ki,vi,ti) übermittelt, die in den Speicher (SP) eingesteckte Speichermodule (SM) sowie deren Speicherkapazität anzeigen und mit deren Hilfe Einstellinformationen für die Ansteuerung des Speichers (SP) ermittelt werden.

## Beschreibung

Speicher werden üblicherweise durch Einsetzbereiche gebildet, in die Speichermodule einsetzbar sind. Hierbei stellen die Einsetzbereiche Steckplätze dar, in die Speichermodule unterschiedlichster Typen mit unterschiedlichen Speicherkapazitäten einsteckbar sind. Die Einsetzbereiche bzw. die Steckplätze sind hierbei auf handelsübliche Speichermodule bzw. Speicherbausteine abgestimmt. Das Lesen und Schreiben von Informationen in den Speicher wird üblicherweise mit einer Speicheransteuerung durchgeführt. Neben den für die Übermittlung der gelesenen oder zu schreibenden Daten erforderlichen Datenleitungen sind n Adreßleitungen - beispielsweise 13 Adreßleitungen - von der Speicheransteuerung zu den Einsetzbereichen bzw. Steckbereichen geführt. An diese Adreßleitungen werden in der Speicheransteuerung derart Spannungspotentiale gesteuert, daß binär codierte Adresseninformationen an alle Einsetzbereiche bzw. an in diese gesteckte bzw. eingesetzte Speichermodule gelangen.

Für eine fehlerfreie Ansteuerung muß der Speicheransteuerung die Konfiguration des Speichers der Speicheranordnung bekannt sein. Dies bedeutet, daß in der Speicheransteuerung Wissen über das Vorhandensein von Speichermodulen in den Einsetzbereichen und Wissen über die Speicherkapazität der eingesetzten Speichermodule verfügbar sein muß. Dies wird üblicherweise durch an den Anschlüssen der Speicheransteuerung angelegte Information - beispielsweise Spannungspotentiale - oder durch eine Programmierung eines internen Speichers erreicht. Dies bedeutet zusätzlichen Einstellungs- bzw. Programmieraufwand.

Die der Erfindung Zugrundeliegende Aufgabe besteht darin, diesen zusätzlichen Einstellungs- bzw. Programmieraufwand zu verringern. Die Aufgabe wird durch die Merkmale des Anspruchs 1 gelöst.

Der wesentliche Aspekt des erfindungsgemäßen Verfahrens ist darin zu sehen, daß zumindest eine der zu den Einsetzbereichen geführten Steuerleitungen oder Adreßleitungen als zusätzliche Informationsleitung benutzt wird. Hierzu sind zum Bilden und Übermitteln von Kapazitätsinformationen über eine Kapazitätsleitung - Anspruch 2 - und Vorhandenseininformationen über eine Vorhandenseinleitung - Anspruch 3 - Kodierungsmittel vorgesehen, wobei die Vorhandenseininformationen in den Einsetzbereich eingesetzte Speichermodule - d.h. deren Vorhandensein - und die Kapazitätsinformationen deren Speicherkapazität anzeigen. In der Speicheransteuerung sind zur einsetzbereichsindividuellen Bewertung der über die Kapazitätsleitung und Vorhandenseinleitung übermittelten Kapazitäts- und Vorhandenseininformationen Bewertungsmittel vorgesehen.

Gemäß einer vorteilhaften Weiterbildung des erfindungsgemäßen Verfahrens ist für jeden der Einsetzbereiche jeweils zumindest eine der weiteren Adreß- oder Steuerleitungen als Typenleitungen bestimmt. Zusätzliche, einsetzbereichindividuelle Kodiermitteln sind zum Bilden und Übermitteln von speichermodulindividuellen Typeninformationen vorgesehen, wobei die Typeninformationen jeweils den Typ des eingesetzten Speichermoduls anzeigen. Hierzu sind zusätzliche Bewertungsmittel in der Speicheransteuerung zur einsetzbereichindividuellen Bewertung und Speicherung der über die Typenleitung übermittelten Typeninformationen vorgesehen - Anspruch 4. Dies bedeutet eine Erweiterung des erfindungsgemäßen Verfahren für das Übermitteln einer im Speichermodul angegebenen Typeninformation - beispielsweise DRAM oder SRAM - an die Speicheransteuerung.

Gemäß einer vorteilhaften Weiterbildung des erfindungsgemäßen Verfahrens sind als Kodiermittel in der Speicheransteuerung ein vorgegebener, mit einem vorgegebenen Spannungspotential verbundener Widerstand an die Kapazitäts-, Vorhandensein- bzw. Typenleitung geschaltet und in jedem in einen Einsetzbereich eingesetzten Speichermodul wird ein sein Vorhandensein bzw. seine Speicherkapazität bzw. seinen Typ anzeigender Widerstand mit der jeweiligen Kapazitäts-, bzw. Vorhandensein bzw. Typenleitung und einem vorgegebenen Spannungspotential verbunden - Anspruch 5 . Dies bedeutet, daß beispielsweise in Abhängigkeit von der Speicherkapazität des Speichermoduls - beispielsweise ein oder vier MByte - der Widerstand bestimmt wird, der sowohl mit der Kapazitätsleitung als auch mit einem vorgegebenen Spannungspotential verbunden ist. Bei einem mit einem vorgegebenen Spannungspotential vorgegebenem Widerstand in der Speicheransteuerung treten am Spannungsteilerpunkt der Kapazitätsleitung in Abhängigkeit von der Höhe des im Einsetzbereich bzw. Speichermodul eingestellten Widerstandes unterschiedliche Spannungspotentiale auf, durch die die Speicherkapazität, das Vorhandensein bzw. der Typ des eingesetzten Speichermoduls der Speicheransteuerung angezeigt wird. Um eine eindeutige Spannungsteilerfunktion zu erreichen, ist in der Speicheransteuerung der Widerstand mit dem der Spannungsversorgung entsprechenden Spannungspotential und in den Einsetzbereichen mit dem Massepotential verbunden - Anspruch 6. Der in der Speicheransteuerung je Kapazitäts-, Vorhandensein- bzw. Typenleitung vorgesehene Widerstand ist derart zu dimensionieren, daß durch die Speicheransteuerung Spannungspotentiale zur Adreß- und Steuerinformationsbildung an die n Adreßleitungen bzw. Steuerleitungen steuerbar sind, wobei während der Übermittlung der Konfigurationsinformationen die Steuer- bzw. Adreßinformationsbildung unwirksam geschaltet ist - Anspruch 7. Dies bedeutet, daß in der Speicheransteuerung und in den Einsetzbereichen die Widerstände derart zu dimensionieren sind, daß die Spannungspotentiale zur Adreß- und Steuerinformationsbildung auf die n Adreß- bzw. Steuerleitungen aufgeschaltet werden können und Spannungspotentiale erreicht werden, durch die der Speicher adressiert bzw. die entprechende Steuerung bewirkt werden kann. Zur Identifizierung der Einsetzbereiche sind bei mehreren Kapazitätsleitungen die Kapazitäts-, Vorhandensein- bzw. Typeninformation durch binär kodierte Kapazitäts-, Vorhandensein- bzw. Typeninformation gebildet - Anspruch 10. Dies bedeutet, daß an die Kapazitäts- Vorhanden- bzw. Typenleitungen jeweils ein die binäre 0 - oder 1-Information repräsentierendes Spannungspotential derart gesteuert wird, daß durch die Zusammenbetrachtung der an den Kapazitäts-, Vorhandensein- bzw. Typenleitungen vorliegenden Spannungspotentiale eine binär kodierte Kapazitäts-, Vorhandensein- bzw. Typeninformation repräsentiert ist.

Weitere vorteilhafte Ausgestaltungen der erfindungsgemäßen Anordnung sind den weiteren Ansprüchen zu entnehmen.

Im folgenden wird die erfindungsgemäße Anordnung anhand eines Blockschaltbildes näher erläutert. Das Blockschaltbild zeigt eine Speicheransteuerung SAS und zwei von vier Einsatzbereichen EB1...4, die zusammen den Speicher SP bilden. Anstelle der vier Einsetzbereiche EB1...4 können erfindungsgemäß unterschiedliche, an den jeweiligen Anwendungsfall anpaßbare Einsetzbereiche ausgestaltet werden. Bezogen auf das Ausführungsbeispiel sei des weiteren angenommen, daß in diese Einsatzbereiche EB1...4, die durch geeignete Steckplätze realisiert sind, Speichermodule SM mit einer Speicherkapazität K1,4 von ein oder vier MByte eingesetzt bzw. eingesteckt werden können. Im Ausführungsbeispiel stellen die Speichermodule SM kleine gedruckte Platinen mit integrierten RAM-Speicher (Random Access Memory) dar, die beispielsweise auch in Personalcomputern verwendet werden - im Blockschaltbild durch ein in Klammern gesetztes Wort RAM angedeutet.

Die Speicheransteuerung SAS enthält eine Steuerung ST, die die bekannten Funktionen einer handelsüblichen RAM-Speicheransteuerung - in der Fachwelt als RAM-Controller bekannt - enthält.

Von jedem Einsetzbereich EB1...4 sind jeweils zwei Steuerleitungen SL1..8 in die Speicheransteuerung SAS geführt. Über diese Steuerleitungen SL1..8 werden bespielsweise von der Speicheransteuerung SAS häufig verwendete RAS-Signale RAS0.. 7 (Row Address Strobe) übertragen. Zusammen mit einem CAS-Signal (Column Address Strobe) werden die Spalten bzw. Reihen des Speichers SP adressiert, d.h. bei einem vorgegebenen Spannungspotential werden die vorliegenden Adressen als Reihen- bzw. Spaltenadressen bestimmt. Bei nicht vorliegendem RAS-Signal RAS0...7 weisen die Steuerleitungen SL1..8 jeweils ein hohes Spannungspotential auf, wobei diese Spannung in der Praxis aufgrund von Realisierungstoleranzen unterschiedlich sein kann. Um diese Spannungsschwankungen zu vermeiden, ist in der Speicheransteuerung SAS jede Steuerleitung SL1..8 über einen Vorwiderstand RV an die stabilisierte Versorgungsspannung +V geführt - im Blockschaltbild für die acht Steuerleitungen SL1..8 beispielhaft einmal dargestellt. Des weiteren ist in der Speicheransteuerung SAS jeweils eine Leitungssendeempfangseinheit LSE an jede Steuerleitung SL1..8 angeschlossen - beispielhaft ist im Blockschaltbild eine der acht Leitungssendeempfangseinheiten LSE dargestellt. In jeder der Leitungssendeempfangseinheiten LSE ist die Steuerleitung SL1..8 an den Eingang eines Leitungsverstärkers LV und einen Ausgang eines weiteren Leitungsverstärkers LV geführt. Der Ausgang bzw. der Eingang der beiden Leitungsverstärker LV ist mit der Steuerung ST verbunden. Durch die Leitungsverstärker LV werden die empfangenen bzw. zu übermittelnden Spannungspotentiale unverändert weitergeleitet, wobei lediglich eine Impedanztransformation durchgeführt wird. Während dem Übermitteln der Kapazitäts-, Vorhandensein und der Typeninformation ki,vi,ti werden die in Richtung Einsetzbereiche EB1..4 wirkende Leitungsverstärker LV hochohmig, d.h. unwirksam gesteuert. Der in Richtung Steuerung ST wirkende Leitungsverstärker LV bleibt wirksam und leitet das am Spannungsteilerpunkt SPT auftretende Spannungspotential im Sinne einer Messung und Bewertung an die Steuerung ST weiter.

In jedem der Einsetzbereiche EB1...4 ist eine der Steuerleitungen SL1..8 als Kapazitätsleitung und eine als Vorhandenseinleitung bestimmt - im Ausführungsbeispiel für den ersten Einsetzbereich EB1 die erste Steuerleitung SL1 als Kapazitätsleitung und die zweite Steuerleitung SL2 als Vorhandenseinleitung. Die beiden Steuerleitungen SL1..8 eines Einsetzbereiches EB1..4 sind jeweils mit einem Widerstand R1..8 verbindbar. Die Anschlußkonfiguration der beiden Widerstände R1..8 wird in Abhängigkeit von dem Vorhandensein von einem gesteckten Speichermodul SM und dessen Speicherkapazität durchgeführt. Ist kein Speichermodul SM gesteckt, ist kein zweiter Widerstand R2,4,6,8 vom negativen Spannungspotential -V - in der Praxis Massepotential - zu der jeweiligen die Vorhandenseinleitung reprasentierende Steuerleitungen SL2,4,6,8 geschaltet. Beim Einsetzen eines Speichermoduls SM wird ein auf der Platine bzw. dem Speichermodul SM angeordneter zweiter Widerstand R2,4,6,8 von Massepotential -V zu der jeweiligen die Vorhandenseinleitung repräsentierende Steuerleitung SL2,4,6,8 geschaltet. Dies bedeutet, daß in der Speicheransteuerung SAS der Spannungspegel am Spannungsteilerpunkt SPT für die jeweilige Steuerleitung SL2,4,6,8 auf einen niedrigen Spannungspegel absinkt, sofern der in Richtung Einsetzbereiche EB1..4 wirkende Leitungsverstärker LV durch die Steuerung ST hochohmig gesteuert ist. Der niedrige Spannungspegel zeigt folglich der Speicheransteuerung an, daß ein Speichermodul SM in dem jeweiligen Einsetzbereich EB1 gesteckt ist und ein hohes Spannungspotential zeigt an, daß kein Speichermodul SM in dem jeweiligen Einsetzbereich EB1..4 gesteckt ist. Entsprechend den durch die Steuereinheit ST gemessenen Spannungspegel wird in dieser eine Vorhandenseininformation vi gebildet - vorteilhaft durch eine binäre Information repräsentiert - und gespeichert. Die Steuerung ST schaltet die in Richtung Einsetzbereiche EB1..4 wirkende Leitungsverstärker LV lediglich zur Messung der übermittelten Kapazitäts-, Vorhandensein- und Typeninformation ki,vi,ti hochohmig.

Bei einem gesteckten Speichermodul SM in einem Einsetzbereich EB1..4 durch die Konfiguration des ersten Widerstandes R1,3,5,7 die Speicherkapazität angegeben. Ist kein erster, im Speichermodul SM anzuordnender Widerstand R1,3,5,7 von Massepotential -V zur jeweiligen die Kapazitätsleitung repräsentierende Steuerleitung SL1,3,5,7 geschaltet, so weist das eingesetzte Speichermodul SM eine große Speicherkapazität - beispielsweise 4 Mbyte - auf und ist ein erster Widerstand R1,3,5,7 geschaltet, so weist das eingesetzte Speichermodul SM eine kleine Speicherkapazität auf - beispielsweise 1 Mbyte.

In der Speicheransteuerung SAS treten am Spannungsteilerpunkt SPT der jeweiligen Steuerleitung SL1,3,5,7 in Abhängigkeit von der Konfiguration des ersten Widerstandes R1,3,5,7 unterschiedliche Spannungspegel auf, die an die Steuereinheit ST über die Leitungssendeempangseinheit LSE weitergeleitet und dort gemessen werden. In Abhängigkeit von der Höhe der gemessenen Spannungspegel werden eine große oder kleine Speicherkapazität anzeigende Kapazitätsinformationen ki für jeden Einsetzbereich EB1..4 gebildet und einsetzbereichsindividuell gespeichert. Die beiden Widerstände R1..8 können jeweils bei der Herstellung der Speichermodule SM bzw. der Platinen konfiguriert, d.h. in diesen in einer fertigungstechnisch wirtschaftlichen Weise eingebracht werden.

Des weiteren sind im Ausführungsbeispiel von der Steuereinheit ST der Speicheransteuerung SAS ausgehend, 13 Adreßleitungen ADL1..13 über jeweils eine Leitungssendeempfangseinheit LSE parallel mit jedem Einsetzbereich EB1...4 verbunden. In den Einsetzbereichen EB1...4 sind die Adreßleitungen ADL an die Speichermodule SM geführt. Für das Ausführungsbeispiel sei angenommen, daß über jeweils eine der Adreßleitungen ADL1..13 eine zusätzliche Konfigurationsinformation, nämlich eine Typeninformation ti übermittelt werden soll. Hierzu ist die erste bis vierte Adreßleitung ADL1..4 für den ersten bis vierten Einsetzbereich EB1..4 als Typenleitung bestimmt. Als Typeninformation ti repräsentiert beispielsweise ein hohes Spannungspotential ein'schnelles Speichermodul' und ein niedriges Spannungspotential ein 'langsames Speichermodul'.

Analog zur Beschaltung der Steuerleitungen SL1...8 sind die vier bestimmten Adreßleitungen ADL1..4 in der Speicheransteuerung SAS jeweils über einen Widerstand RV mit der positiven Versorgungsspannung +V verbunden - in dem Blockschaltbild durch den Widerstand RV angedeutet. In den Einsetzbereichen EB1...4 ist an die zugeordnete Adreßleitungen ADL1..4 ein mit dem Massepotential -V verbundener Typenwiderstand RT schaltbar - im Blockschaltbild durch einen dargestellten Widerstände RT angedeutet. Bezogen auf das Ausführungsbeispiel sind bei eingestzten schnellen Speichermodulen SM keine Widerstände RT und bei eingesetzten langsamen Speichermodulen SM Widerstände RT geschaltet. Die Übermittlung und Messung des Spannungspotentials am Spannungsteilerpunkt SPT erfolgt in analoger Weise wie bei der Übermittlung und Messung der Kapazitäts- und Vorhandenseininformation vi. Durch diese Messungen können Fehlbestückungen der Einsetzbereiche EB1..4 festgestellt werden, d.h. alle Einsetzbereiche EB1..4 müssen mit langsamen oder schnellen Speichermodulen SM bestückt sein, da Speichermodule SM mit unterschiedlichen Zugriffsgeschindigkeiten nicht zusammenwirken. In den jeweiligen Einsetzbereichen EB1..4 sind die unbeschalteten - d.h. keine Widerstandsbeschaltung aufweisenden - Adreßleitungen ADL2-12..A1-3/5-13 an die Steckeinrichtungen der Speichermodule SM geführt.

Bei mehreren Adreßleitungen ADL wird alternativ eine zu übermittelnde Typeninformation ti durch eine binäre Kodierung der Adreßleitungen ADL angegeben - nicht dargestellt -, wobei ein nicht geschalteter Widerstand RT hohes Potential und damit eine binäre 1-Information und ein geschalteter Widerstand RT ein niedriges Spannungspotential und damit eine binäre 0-Information am Spannungsteilerpunkt SP bedeutet. Durch die Typeninformation ti wird insbesondere der Typ des eingesetzten Speichermoduls SM über die vorhandenen Adreßleitungen ADL angegeben - z.B. SRAM oder DRAM -, wobei jeweils eine vorgegebene Anzahl von Adreßleitungen ADL einem Einsetzbereich EB1..4 zugeordnet ist. Da die Speichermodule SM üblicherweise durch unterschiedlichste Bausteine und Bausteintypen realisiert sind, ist durch Übermitteln der Typeninformation ti an die Steuereinheit ST der Speicheransteuerung SAS eine Überprüfung dahingehend möglich, inwieweit einheitliche oder in der Praxis zusammenarbeitende Speicherbausteintypen in die jeweiligen Einsetzbereiche EB1...4 eingesetzt sind.

Durch die erfindungsgemäße Anordnung ist folglich sowohl ein Übermitteln von Kapazitäts- und Vorhandenseininformation ki,vi als von Typeninformationen ti und von weiteren, nicht beschriebenen Konfigurationsinformationen möglich, wodurch in der Steuereinheit ST ein umfangreiches Wissen über die Speicherkapazität und das Vorhandensein von Speichermodulen SM und ein Wissen über die verwendeten Speicherbausteintypen vorliegt. Hierbei werden die an den Spannungsteilerpunkten SPT der die Typenleitungen repräsentierenden Adreßleitungen ADL anliegenden Spannungspotentiale über die Leitungssendeempfangseinheiten LSE an die Steuereinheit ST weiergeleitet. In dieser werden die Spannungspotentiale gemessen und nach einer Dekodierung als Typeninformation - vorteilhaft in einer binären Form - gespeichert. Zu beachten ist hierbei, daß jeweils bestimmte Adreßleitungen ADL unter Berücksichtigung des eingesetzten Adressierungsverfahren bzw. der Adressierungsmethode bestimmten Einsetzbereichen EB1..4 zugeordnet werden, um eine eindeutige Zuordnung der übermittelten Typeninformationen ti zu den Einsetzbereichen EB1..4 zu erreichen.

Die Messung der am Spannungsteilerpunkt SPT anliegenden Spannungspotentiale kann durch einen extern angeordneten Analog/Digitalwandlerbaustein oder durch einen in die Steuereinheit ST integrierten oder bereits in dieser vorhandenen Analog/Digitalwandlerbaustein - nicht dargestellt - durchgeführt werden. Bei einer externen Anordnung sind die Leitungssendeempfangseinheiten LSE extern, d.h. nicht in der Speicheransteuerung SAS zu realisieren. Anhand der gespeicherten Konfigurationsinformationen ki,vi,ti kann durch die Steuereinheit ST der Speicheransteuerung SAS selbständig, d.h. automatisch eine geeignete Einstellung zur Ansteuerung der eingesetzten Speichermodule SM ermittelt werden, wobei die Speicheransteuerung SAS bekannterweise mit einem Mikroprozessor MP verbunden ist, der die Speicheransteuerung SAS steuert und überwacht.

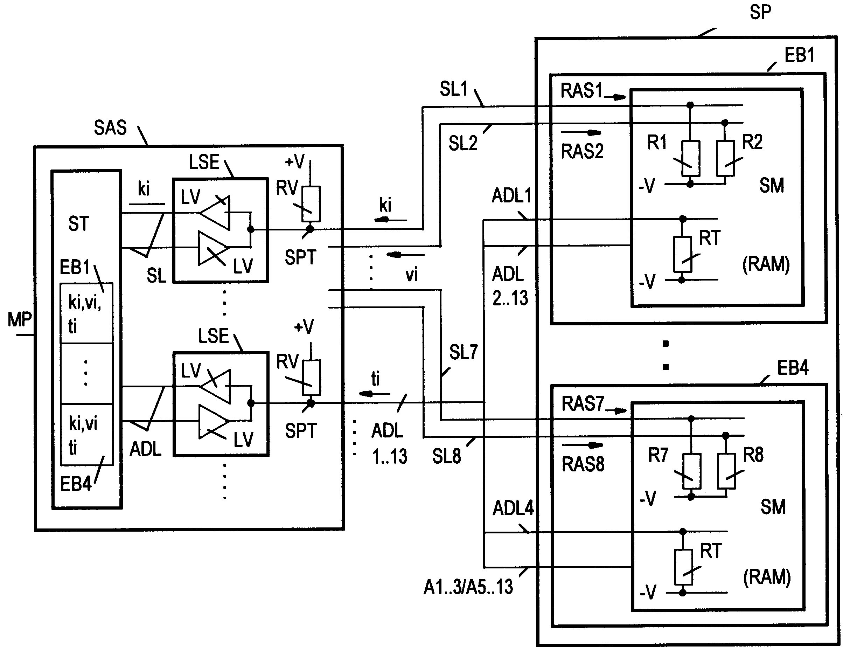

## Patentansprüche

1. Anordnung zum Ermitteln der Konfiguration eines Speichers (SP), der durch Speichermodule (SM) aufnehmende Einsetzbereiche (EB1..4) gebildet ist, an die von einer Speicheransteuerung (SAS) ausgehende Adreßleitungen (ADL1..13) parallel geführt sind und mit zumindest jeweils einer einsetzbereichindividuelle Steuerleitung (SL1..8) von der Speicheransteuerung (SAS) zu jedem Einsetzbereich (EB1..4),
- bei der für jeden Einsetzbereich (EB1..4) zumindest eine der Adreß- oder Steuerleitungen (ADL1..13,SL1..8) als Informationsleitung bestimmt ist,
- mit Kodiermitteln (RV,R1,R2) zum Bilden und Übermitteln von einsetzbereichsindividuellen Konfigurationsinformationen (vi,ki,ti) vom Speicher (SP) über die zumindest eine Informationsleitung zur Speicheransteuerung (SAS), und
- mit Bewertungsmitteln (ST) in der Speicheransteuerung (SAS) zur einsetzbereichsindividuellen Bewertung und Speicherung der über die Informationsleitung übermittelten Konfigurationsinformationen (ki,vi,ti) .

2. Anordnung nach Anspruch 1, dadurch **gekennzeichnet**,
- daß für jeden Einsetzbereich (EB1..4) zumindest jeweils eine der zwischen der Speicheransteuerung (SAS) und einem Einsetzberech (EB1..4) geführten Adreß- oder Steuerleitungen (SL1..8,ADL1..13) als Kapazitätsleitung (SL1,3,5,7) bestimmt ist, und
- daß einsetzbereichindividuelle Kodiermittel (R1,R2,RV) zum Bilden und Übermitteln von Kapazitätsinformationen (ki) über die jeweilige Kapazitätsleitung vorgesehen sind, wobei die Kapazitätsinformationen (ki) jeweils die Speicherkapazität der eingesetzte Speichermodule (SM) anzeigen.

3. Anordnung nach Anspruch 1 oder 2, dadurch **gekennzeichnet**, daß für jeden Einsetzbereich (EB1..4) zumindest jeweils eine der weiteren zwischen der Speicheransteuerung (SAS) und einem Einsetzberech (EB1..4) geführten Adreß- oder Steuerleitungen (SL1..8,ADL1..13) als Vorhandenseinleitung (SL2,4,6,8) bestimmt ist, und
- daß einsetzbereichindividuelle Kodiermittel (R1,R2,RV) zum Bilden und Übermitteln von Vorhandenseininformationen (vi) über die jeweilige Vorhandenseinleitung vorgesehen sind, wobei die Vorhandenseininformation (vi) jeweils das Vorhandensein eines in den jeweiligen Einsetzbereich (EB1..4) eingesetzten Speichermoduls (SM) anzeigen.

4. Anordnung nach einem der Ansprüche 1 bis 3, dadurch **gekennzeichnet**,
- daß für jeden der Einsetzbereiche (EB1..4) jeweils zumindest eine der weiteren Adreß- oder Steuerleitungen (ADL1..13,SL1..8) als Typenleitungen (ADL1..4) bestimmt ist,
- daß zusätzliche, einsetzbereichindividuelle Kodiermitteln (RV,TR) zum Bilden und Übermitteln von speichermodulindividuellen Typeninformationen (ti) vorgesehen sind, wobei die Typeninformationen (ti) jeweils den Typ des eingesetzten Speichermoduls (SM) anzeigen, und
- daß zusätzliche Bewertungsmittel (ST) in der Speicheransteuerung (SAS) zur einsetzbereichindividuellen Bewertung und Speicherung der über die Typenleitung übermittelten Typeninformationen (ti) vorgesehen sind.

5. Anordnung nach einem der Ansprüche 1 bis 4, dadurch **gekennzeichnet**,
daß als Kodiermittel (RV,RT,R1,2)
- in der Speicheransteuerung (SAS) ein vorgegebener, mit einem vorgegebenen Spannungspotential (+V) verbundener Widerstand (RV) an jede Kapazitäts-, Vorhandensein bzw. Typenleitung geschaltet ist, und
- in dem jedem in einen Einsetzbereich (EB1..4) eingesetzten Speichermodul (SM) ein sein Vorhandensein bzw. seine Speicherkapazität bzw. seinen Typ anzeigender Widerstand (R1,2,RT) mit der jeweiligen Kapazitäts-, bzw. Vorhandensein bzw. Typenleitung und einem vorgegebenen Spannungspotential (-V) verbunden ist.

6. Anordnung nach Anspruch 5, dadurch **gekennzeichnet**, daß in der Speicheransteuerung (SAS) die Widerstände (RV) mit dem zur Spannungsversorgung vorgesehenen Spannungspotential (+V) und in den Einsetzbereichen (EB1..4) die Widerstände (R1,2,RT) mit dem Massespotential (-V) verbunden sind.

7. Anordnung nach Anspruch 5 oder 6, dadurch **gekennzeichnet**,
daß die je Kapazitäts-, Vorhandensein bzw. Typenleitung vorgesehenen Widerstände (RV,R1,R2,RT) in der Speicheransteuerung (SAS) und den Einsetzbereichen (EB1..4) derart dimensioniert sind, daß durch die Speicheransteuerung (SAS) im Sinne einer Steuer- bzw. Adreßinformationsbildung gebildeten Spannungspotentiale an die Steuerleitungen (SL1..8) bzw. Adreßleitungen (ADL1..13) steuerbar sind, wobei während der Übermittlung der Konfigurationsinformationen (ki,vi,ti) die Steuer- bzw. Adreßinformationsbildung unwirksam geschaltet ist.

8. Anordnung nach Anspruch 7, dadurch **gekennzeichnet**,
daß in der Speicheranordnung (SAS) Spannungsbewertungsmittel (ST) für die Bewertung der an der Kapazitäts-, Vorhandensein- bzw. Typenleitung anliegenden Spannungspotentale vorgesehen und derart ausgestaltet sind, daß in Abhängigkeit von dem anliegenden Spannungspotential für jeden Einsetzbereich EB1..4 eine die Speicherkapazität, das Vorhandensein bzw. den Typ des eingesetzten Speichermoduls (SM) anzeigende Kapazitäts, Vorhandensein- bzw. Typeninformation (ki,vi,ti) speichergemäß gebildet und gespeichert wird, wobei die Mittel (LV) zur Übermittlung der Steuer- und Adreßinformationen an die Einsetzbereiche (EB1..4) hochohmig geschaltet sind.

9. Anordnung nach Anspruch 8, dadurch gekennzeichnet,
daß die Kapazitäts-, Vorhandensein- bzw. Typeninformation (ki,vi,ti) durch binäre Informationen repräsentiert und gespeichert sind.

10. Anordnung nach einem der vorhergehenden Ansprüche, dadurch **gekennzeichnet**,
daß bei mehreren Kapazitäts-, Vorhandensein- bzw. Typenleitungen die Kapazitäts-, Vorhandensein- bzw. Typeninformation (ki,vi,ti) durch binär kodierte Kapazitäts-, Vorhandensein- bzw. Typeninformationen gebildet sind.

11. Anordnung nach Anspruch 10, dadurch **gekennzeichnet**,
daß in der Speicheransteuerung (SAS) zusätzliche Dekodiermittel (ST) für die Bewertung der an der Kapazitäts- bzw. Vorhandensein- bzw. Typenleitungen anliegenden binär kodierten Spannungspotentale vorgesehen und derart ausgestaltet sind, daß in Abhängigkeit von dem anliegenden, binär codierten Spannungspotentialen eine die Speicherkapazität, das Vorhandensein bzw. den Typ des eingesetzten Speichermoduls (DM) anzeigende Kapazitäts-, Vorhandensein- bzw. Typeninformation (ki,vi,ti) gebildet und gespeichert wird.
